# EUROPÄISCHE PATENTSCHRIFT

(11) **EP 1 238 457 B1**
(45) Veröffentlichungstag und Bekanntmachung des Hinweises auf die Patenterteilung: **10.01.2007**
(21) Anmeldenummer: 00979544.4
(22) Anmeldetag: 09.11.2000
(51) Int. Cl.: H03G 3/30

(54) **ANORDNUNG ZUM REGELN DER AUSGANGSLEISTUNG EINES HF-SENDERS**
ARRANGEMENT FOR CONTROLLING THE OUTPUT POWER OF AN HF TRANSMITTER
DISPOSITIF PERMETTANT DE REGULER LA PUISSANCE DE SORTIE D'UN EMETTEUR HF

(30) Priorität: 09.12.1999 DE 19959403
(43) Veröffentlichungstag der Anmeldung: 11.09.2002
(73) Patentinhaber: Rohde & Schwarz GmbH & Co. KG, 81671 München (DE)
(72) Erfinder: BÖGL, Thomas, 86179 Augsburg (DE); RITSCHEL, Reinhard, 84478 Waldkraiburg (DE); VALTEN, Thomas, 82008 Unterhaching (DE)
(74) Vertreter: Körfer, Thomas
(86) Internationale Anmeldenummer: PCT/EP2000/011095
(87) Internationale Veröffentlichungsnummer: WO 2001/043281

(56) Entgegenhaltungen:
- EP-A- 0 565 507
- EP-A- 0 612 144
- GB-A- 2 301 247
- US-A- 4 933 986

## Beschreibung

Die Erfindung betrifft eine Anordnung zum Regeln der Ausgangsleistung eines HF-Senders laut Oberbegriff des Hauptanspruches.

Regelanordnungen dieser Art sind bekannt. Sie werden dazu benutzt, die eingestellte Ausgangsleistung eines Senders, die von vielen Größen beeinflußt werden kann, auf einen konstanten Wert zu regeln. Dabei wird die Ausgangsleistung gemessen und mit einem vorgegebenen Sollwert verglichen. Ein Regelkreis gleicht die Veränderungen gegenüber dem Sollwert aus, indem ein veränderbares Stellglied im Aufbereitungszug des Senders zur Einstellung der Verstärkung und damit der Ausgangsleistung entsprechend geregelt wird. Dieses Stellglied ist bei den bekannten Anordnungen beispielsweise ein regelbarer Verstärker oder ein variables Dämpfungsglied (siehe z.B. EP 0612144, 24. Aug. 1994). Mit einem regelbaren Verstärker bleibt der Arbeitspunkt nicht konstant, regelbare Dämpfungsglieder sind vom Wirkungsgrad her nachteilig.

Es ist daher Aufgabe der Erfindung, eine Regelanordnung dieser Art für Hochfrequenzsender zu schaffen, die diese Nachteile vermeidet und möglichst schon vorhandene Baugruppen des Senders hierfür ausnutzt.

Diese Aufgabe wird ausgehend von einer Anordnung laut Oberbegriff des Hauptanspruches durch dessen kennzeichnende Merkmale gelöst. Vorteilhafte Weiterbildungen ergeben sich aus den Unteransprüchen.

Gemäß der Erfindung wird als Stellglied ein üblicher I/Q-Modulator bzw. Quadraturmischer benutzt, dessen Ausgangsamplitude in an sich bekannter Weise entsprechend geregelt wird, was gleichbedeutend ist mit einer Veränderung der Steuerleistung. Dabei kann es sich um einen analogen oder digitalen I/Q-Modulator handeln. Besonders vorteilhaft ist es, hierfür den I/Q-Modulator zu benutzen, der in vielen Hochfrequenzsendern sowieso zur Erzeugung der komplexen Modulation vorhanden ist. Dabei wird für die Leistungsregelung ein gesondertes Stellglied überflüssig. Eine erfindungsgemäße Anordnung besitzt auch noch den Vorteil eines konstanten Arbeitspunktes des gesamten Verstärkerzuges, da für die Regelung keine Arbeitspunktverschiebung erforderlich ist, wie dies bei regelbaren Verstärkern der Fall ist. Die erfindungsgemäße Anordnung eignet sich für jede Art von I/Q-Modulation, die über den Sender übertragen wird.

Die Erfindung wird im Folgenden anhand einer schematischen Zeichnung an einem Ausführungsbeispiel näher erläutert.

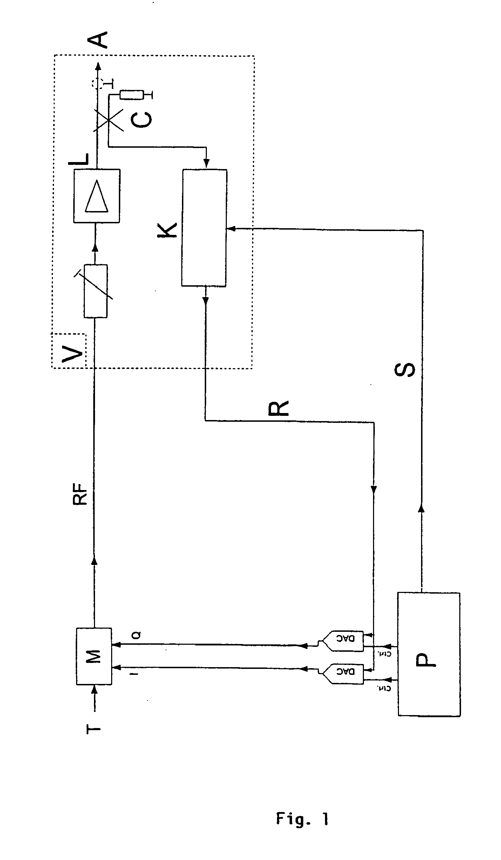

Die Figur zeigt das Prinzipschaltbild eines Hochfrequenzsenders, bei dem mittels eines analogen I/Q-Modulators M eine komplexe Modulation eines Hochfrequenzträgers T vorgenommen wird. Das modulierte Hochfrequenzsignal RF wird in einem nachfolgenden Leistungsverstärker V auf die gewünschte Senderleistung verstärkt und über die Antenne A abgestrahlt. Die beiden komplexen Basisband-Komponenten I und Q, die dem Träger T aufmoduliert werden, werden in einem digitalen Signalprozessor P erzeugt und über zwei Digital/Analog-Wandler DA1 und DA2 als Analogsignal dem I/Q-Modulator M zugeführt. Im Signalprozessor P wird zusätzlich noch ein Ausgangssignal S erzeugt, das der momentanen Soll-Leistung des Senders entspricht und das als Sollwertsignal einem Komparator K zugeführt wird, in welchem es mit der Ausgangsleistung der Leistungsendstufe V verglichen wird, die am Ausgang des Leistungsverstärkers L über einen Richtkoppler C ausgekoppelt wird. Im Komparator K wird durch Vergleich von Sollwert und Istwert ein Regelsignal R erzeugt, das den beiden DA-Wandlern DA 1 und DA2 zugeführt wird. Mit dem Regelsignal R wird so die Amplitude der Basissignalkomponenten I und Q multipliziert, also die Amplitude der I- und Q-Komponenten entsprechend geändert und somit auch in analoger Weise die Steuerleistung des RF-Signals am Ausgang des Modulators M. In dem gezeigten Ausführungsbeispiel erfolgt die Multiplikation durch Variation der Referenzspannung der D/A-Wandler DA1 und DA2. Diese Anordnung besitzt den Vorteil, daß der Signalprozessor P nicht direkt in den Regelkreis eingebunden ist und so Rechenleistung gespart wird.

Wenn keine Sollgröße in Form der momentanen Leistung S aus dem Signalprozessor P zur Verfügung steht, kann auch eine einfache Gleichspannung als Sollwert im Komparator K benutzt werden. In diesem Fall ist dann eine Mittelwertregelung vorgesehen. Es wäre auch möglich, über eine A/D-Wandlung des Regelsignals R ein entsprechendes Digitalsignal zu erzeugen, das dann unmittelbar im Signalprozessor P so verarbeitet wird, daß die Steuerleistung am Ausgang des Modulators entsprechend verändert wird.

Die erfindungsgemäße Regelanordnung mit einem I/Q-Modulator als Stellglied kann auch angewendet werden, wenn über den I/Q-Modulator M keine zusätzliche Modulation erfolgt, die ankommende Steuerleistung also schon moduliert ist und der I/Q-Modulator als Quadraturmischer benutzt wird. In diesem Fall wird beispielsweise unmittelbar im digitalen Signalprozessor P über einen entsprechenden Algorithmus ein I/Q-modulierter Zwischenfrequenz-Träger erzeugt, der dann wieder über die I- und Q-Eingänge des Modulators M mit dem unmodulierten Träger T zum gewünschten Hochfrequenzausgangssignal RF gemischt wird. In diesem Fall erfolgt die Regelung der Amplitude am Ausgang des Modulators bzw. Mischers M durch Berücksichtigung der Regelgröße R im Algorithmus des Prozessors P bei der Erzeugung des modulierten Zwischenfrequenzsignals auf rein digitalem Wege.

## Patentansprüche

1. Anordnung zum Regeln der Ausgangsleistung eines Hochfrequenzsenders, bei der in Abhängigkeit von einem durch Vergleich der Ausgangsleistung mit einem Sollwert (S) gewonnenen Stellgröße mittels eines Stellgliedes die Steuerleistung der Senderendstufe geregelt wird,
**dadurch gekennzeichnet,**
**daß** in Abhängigkeit von der Stellgröße (R) die Amplitude des Modulationssignales vor der Modulation geregelt wird.

2. Anordnung nach Anspruch 1,
**dadurch gekennzeichnet,**
**daß** der zur Trägermodulation bzw. Frequenzumsetzung dienende I/Q-Modulator (M) bzw. Quadraturmischer als Stellglied benutzt wird.

3. Anordnung nach Anspruch 1 oder 2,
**dadurch gekennzeichnet,**
**daß** als Stellglied ein im Leistungsaufbereitungszug angeordneter Quadraturmischer benutzt wird und zur Veränderung der Steuerleistung die Amplitude des dem Mischer zugeführten bereits modulierten Signals in Abhängigkeit von der Stellgröße (R) geregelt ist.

4. Anordnung nach einem der vorhergehenden Ansprüche,
**dadurch gekennzeichnet,**
**daß** der Sollwert (S) zur Gewinnung der Stellgröße (R) über den das Modulationssignal erzeugenden Signalprozessor (P) entsprechend der momentanen Leistung erzeugt wird.

## Claims

1. Arrangement for automatically controlling the output power of a radio-frequency transmitter, in which arrangement the driving power of the transmitter output stage is automatically controlled, by means of a final controlling element, as a function of a correcting variable obtained by comparing the output power with a setpoint value (S), **characterized in that** the amplitude of the modulation signal prior to the modulation is automatically controlled as appropriate as a function of the correcting variable (R).

2. Arrangement according to Claim 1, **characterized in** the I/Q modulator (M) or quadrature mixer that serves for carrier modulation or frequency conversion is used as final controlling element.

3. Arrangement according to Claim 1 or 2, **characterized in that** a quadrature mixer arranged in the power processing chain is used as final controlling element, and to vary the driving power, the amplitude of the modulated signal already fed to the mixer is automatically controlled as appropriate as a function of the correcting variable (R).

4. Arrangement according to one of the preceding claims, **characterized in that**, to obtain the correcting variable (R), the setpoint value (S) is generated by means of the signal processor (P) generating the modulation signal in accordance with the instantaneous power.

## Revendications

1. Dispositif pour réguler la puissance de sortie d'un émetteur de haute fréquence, sur lequel la puissance de commande de l'étage final d'émetteur est réglée en fonction d'une grandeur d'une commande obtenue par comparaison de la puissance de sortie avec une valeur prescrite (S) au moyen d'un actionneur,
**caractérisé en ce que**
l'amplitude du signal de modulation est réglée avant la modulation en fonction de la grandeur de commande (R).

2. Dispositif selon la revendication 1,
**caractérisé en ce que**
le modulateur I/Q (M) ou le mélangeur de quadrature servant à la modulation de porteuse ou la conversion de fréquence est utilisé comme actionneur.

3. Dispositif selon la revendication 1 ou 2,
**caractérisé en ce que**
on utilise comme actionneur un mélangeur de quadrature disposé dans le train de préparation de puissance et, pour modifier la puissance de commande, l'amplitude du signal déjà modulé et amené au mélangeur est réglée en fonction de la grandeur de commande (R).

4. Dispositif selon l'une quelconque des revendications précédentes,
**caractérisé en ce que**
la valeur prescrite (S) pour obtenir la grandeur de commande (R) est générée par le processeur de signal (P) générant le signal de modulation en fonction de la puissance momentanée.
